# EUROPÄISCHE PATENTSCHRIFT

(11) **EP 0 350 015 B1**
(45) Veröffentlichungstag und Bekanntmachung des Hinweises auf die Patenterteilung: **27.09.1995**
(21) Anmeldenummer: 89112292.1
(22) Anmeldetag: 05.07.1989
(51) Int. Cl.: H01L 23/34, H01L 25/18

(54) **Leistungs-MOSFET mit Temperatursensor**
Power MOSFET with a temperature sensor
MOSFET de puissance avec détecteur de température

(30) Priorität: 08.07.1988 DE 8808805 U
(43) Veröffentlichungstag der Anmeldung: 10.01.1990
(73) Patentinhaber: SIEMENS AKTIENGESELLSCHAFT, 80333 München (DE)
(72) Erfinder: Brauschke, Peter, Dipl.-Ing. (FH), D-8000 München 60 (DE); Sommer, Peter, Betrw./Ing., D-8000 München 40 (DE)

(56) Entgegenhaltungen:
- EP-A- 0 067 752
- EP-A- 0 208 970
- EP-A- 0 262 530

## Beschreibung

Die Erfindung bezieht sich auf ein Halbleiterbauelement mit einem Gehäuse, das mindestens einen Leistungs-MOSFET und einen mit diesem thermisch verbundenen Sensor enthält, der temperaturabhängig seinen Widerstand zwischen zwei seiner Anschlüsse ändert, und das mit Anschlüssen des Leistungs-MOSFET verbundene Anschlußleiter hat.

Ein Halbleiterbauelement dieser Art ist z.B. in der EP-A-0 208 970 (DE-A-35 24 517) beschrieben worden. Der Temperatursensor ist hier ein Thyristor, dessen Anoden-Katodenstrecke zwischem dem Gateanschluß und dem Sourceanschluß des MOSFET angeschlossen ist. Der Thyristor ist auf dem Halbleiterkörper des MOSFET angebracht. Er ist mit diesem thermisch verbunden, jedoch elektrisch gegen ihn isoliert. Der Thyristor ist derart dimensioniert, daß er bei Erreichen einer für den MOSFET kritischen Temperatur eingeschaltet wird. Damit wird die Gate-Sourcestrecke des MOSFET kurzgeschlossen und der MOSFET wird gesperrt. Er ist damit gegen Überlastung geschützt.

In der EP-A-0 262 530 ist zusätzlich eine Steuerschaltung vorgesehen, die bei Übertemperatur ein Signal erzeugt. Eine Rückmeldung nach außen erfolgt über einen zusätzlichen Gehäuse anschluß.

Die vorliegende Erfindung hat das Ziel, ein Halbleiterbauelement der beschriebenen Gattung so weiterzubilden, daß der MOSFET bei Erreichen der kritischen Temperatur nicht einfach abgeschaltet wird, sondern daß ein Signal erzeugt wird, das durch eine externe Schaltung den MOSFET ausschalten oder seine Belastung durch Verringern der Leitfähigkeit herabsetzen kann.

Dieses Ziel wird erreicht durch ein Halbleiterbauelement gemäß Anspruch 1. Es weist zwei weitere Anschlußleiter auf, von denen je einer mit je einem der Anschlüsse des Temperatursensors verbunden ist, zwischen denen die Widerstandsänderung auftritt.

Weiterbildungen der Erfindung sind Gegenstand der Unteransprüche. Die Erfindung wird anhand eines Ausführungsbeispiels anhand der Figuren 1 bis 3 näher erläutert. Es zeigen
FIG 1 die Aufsicht auf ein Halbleiterbauelement
FIG 2 das Schaltungsschema des Halbleiterbauelements und
FIG 3 die Aufsicht auf ein Halbleiterbauelement nach der Erfindung ohne Gehäuse.

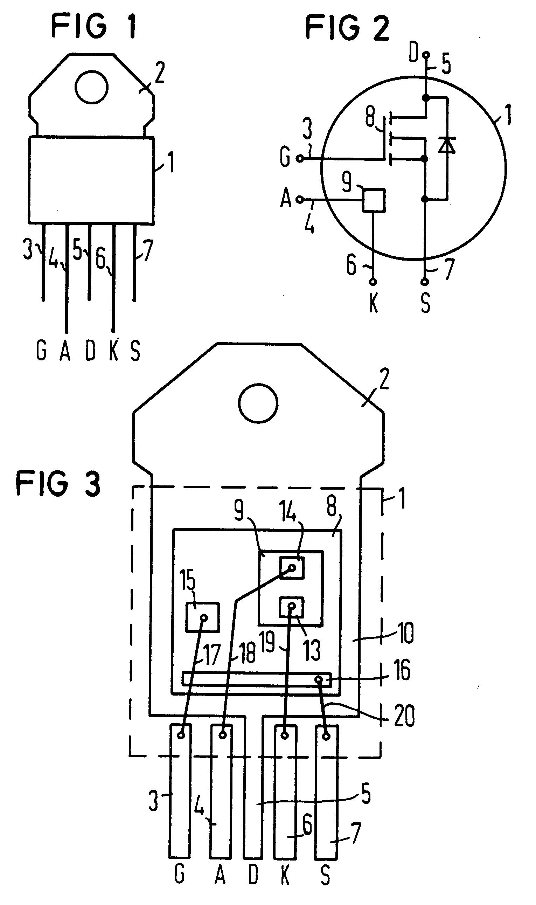

Das Halbleiterbauelement nach FIG 1 hat ein Gehäuse 1, beispielsweise ein Kunststoff-Preßgehäuse. Aus dem Gehäuse ragt eine Befestigungslasche 2 hervor, die auch als Kühlkörper dient. An der der Befestigungslasche entgegengesetzten Seite des Gehäuses 1 sind Anschlußleiter 3, 4, 5, 6 und 7 vorgesehen. Die Anschlußleiter 3, 5 und 7 sind dem Gateanschluß, dem Drainanschluß und dem Sourceanschluß eines MOSFETS 8 (FIG 2) zugeordnet, der sich im Inneren des Gehäuses 1 befindet. Mit dem MOSFET 8 ist ein Temperatursensor 9 thermisch verbunden. Dieser Temperatursensor ändert seinen Widerstand zwischen zwei seiner Anschlüsse abhängig von der Temperatur. Die zwei Anschlüsse sind mit den beiden Anschlußleitern 4 und 6 verbunden. Die Anschlußleiter tragen die Bezeichnung A (Anode) und K (Katode). Der Temperatursensor kann beispielsweise ein Thyristor oder ein Bipolartransistor sein.

Der Aufbau des MOSFET mit Temperatursensor ist in FIG 3 dargestellt. Dabei sind gleiche Teile mit gleichen Bezugszeichen wie in FIG 1 und FIG 2 versehen. Das Gehäuse ist hier entfernt; sein Umfang ist durch eine gestrichelte Linie symbolisiert. Träger für das Halbleiterbauelement ist ein Kühlblech 10, das zusammen mit der Befestigungslasche 2 ein einziges Stück bildet. Auf dem Kühlblech 10 ist der Halbleiterkörper des MOSFET 8 z.B. durch Auflöten aufgebracht. Auf der Oberfläche des Halbleiterkörpers des MOSFET 8 sitzt der Halbleiterkörper des Temperatursensors 9. Dieser hat eine geringere Fläche als der Halbleiterkörper des MOSFET. Der Halbleiterkörper des Temperatursensors hat zwei Anschlüsse 13, 14, die z.B. durch den Anoden- und Katodenkontakt eines Thyristors gebildet sind. Der Gatekontakt des MOSFET ist mit 15 bezeichnet, sein Sourcekontakt mit 16. Die Kontakte 13, 14, 15 und 16 sind durch Bonddrähte 17, 18, 19 und 20 mit den Anschlußleitern 3, 4, 6, 7 elektrisch verbunden. Der den Drainanschluß D bildende Anschlußleiter 5 ist mit dem Kühlblech 10 verbunden, das die Unterseite des MOSFET kontaktiert.

Im Betrieb des MOSFET wird der Widerstand des Temperatursensors an den Anschlußleitern 4 und 6 entweder dauernd oder periodisch abgefragt. Steigt die Temperatur an und wird der Thyristor bei Erreichen einer vorgegebenen Temperatur eingeschaltet, so sinkt der Widerstand zwischen den Kontakten 13 und 14 stark ab. Dies kann in einer externen Überwachungsschaltung dazu benutzt werden, entweder den MOSFET auszuschalten oder den Strom durch den MOSFET durch Ändern der Gate-Sourcevorspannung herabzusetzen.

Anstelle des für den Temperatursensor eingesetzten Thyristors kann auch ein Bipolartransistor verwendet werden. Dieser ändert seinen Widerstand bei Erreichen einer vorgegebenen Temperatur zwar nicht sprungartig wie ein Thyristor, die Größe seines Widerstandes kann jedoch als Maß für die Temperatur des MOSFET herangezogen werden.

## Patentansprüche

1. Halbleiterbauelement mit einem Gehäuse (1), das mindestens einen Leistungs-MOSFET (8) und einen mit diesem thermisch verbundenen Temperatursensor (9) enthält, der temperaturabhängig seinen Widerstand zwischen zwei seiner Anschlüsse (13,14) ändert, und das mit Anschlüssen des Leistungs-MOSFET verbundene Anschlußleiter (3, 5, 7) sowie zwei weitere Anschlußleiter (4, 6) hat,
**dadurch gekennzeichnet** daß je einer der weiteren Anschlußleiter (4, 6) mit je einem derjenigen Anschlüsse (13, 14) des Temperatursensors (9) verbunden ist, zwischen denen die Widerstandsänderung auftritt.

2. Halbleiterbauelement nach Anspruch 1,
**dadurch gekennzeichnet**, daß der Temperatursensor (9) ein Thyristor ist.

3. Halbleiterbauelement nach Anspruch 1, **dadurch gekennzeichnet**, daß der Temperatursensor (9) ein Bipolartransistor ist.

## Claims

1. Semiconductor component having a casing (1), which contains at least one power MOSFET (8) and a temperature sensor (9) which is connected thermally thereto and changes its resistance, as a function of temperature, between two of its terminals (13, 14), and which has connecting conductors (3, 5, 7), connected to terminals of the power MOSFET, as well as two further connecting conductors (4, 6), characterized in that one each of the further connecting conductors (4, 6) is connected to one each of those terminals (13, 14) of the temperature sensor (9) between which the change in resistance occurs.

2. Semiconductor component according to Claim 1, characterized in that the temperature sensor (9) is a thyristor.

3. Semiconductor component according to Claim 1, characterized in that the temperature sensor (9) is a bipolar transistor.

## Revendications

1. Composant à semiconducteur, comportant un boîtier (1) comprenant au moins un transistor (8) MOSFET de puissance, et un capteur (9) de température qui est en relation d'échange thermique avec ce transistor et dont la résistance entre deux de ses bornes (13,14) change en fonction de la température, et le boîtier a des conducteurs (3,5,7) de raccordement reliés à des bornes du transistor MOSFET de puissance, ainsi que deux autres conducteurs (4,6) de raccordement,
caractérisé en ce que chacun des deux autres conducteurs (4,6) de raccordement est relié à l'une des bornes (13,14) du capteur (9) de température, entre lesquelles le changement de résistance apparaît.

2. Composant semiconducteur suivant la revendication 1,
caractérisé en ce que le capteur (9) de température est un thyristor.

3. Composant semiconducteur suivant la revendication 1,
caractérisé en ce que le capteur (9) de température est un transistor bipolaire.
